# EUROPEAN PATENT APPLICATION

(11) **EP 1 703 565 A1**
(43) Date of publication of application: **20.09.2006**
(21) Application number: 04807297.9
(22) Date of filing: 17.12.2004
(51) Int. Cl.: H01L 29/73, H01L 21/331, H01L 27/06

(54) **BIPOLAR TRANSISTOR, SEMICONDUCTOR DEVICE COMPRISING THE BIPOLAR TRANSISTOR AND PROCESS FOR FABRICATING THEM**

(30) Priority: 09.01.2004 JP 2004004186
(71) Applicant: SONY CORPORATION, Tokyo 141-0001 (JP)
(72) Inventor: BAIRO, Masaaki, c/o SONY CORPORATION, Tokyo 1410001 (JP)
(74) Representative: Körber, Martin Hans
(86) International application number: PCT/JP2004/018939
(87) International publication number: WO 2005/067056

(57) **Abstract**

A task is to provide a simple method for obtaining a bipolar transistor being free of current gain dispersion and having a lowered base resistance.

The method of the present invention comprises forming a base layer on a semiconductor substrate, and then forming in an insulating film stacked on the base layer a base electrode lead opening and an emitter electrode lead opening at the same time, and subsequently forming a base electrode lead portion and an emitter electrode lead portion in, respectively, the base electrode lead opening and the emitter electrode lead opening.

## Description

### Technical Field

The present invention relates to a bipolar transistor and a semiconductor apparatus having the bipolar transistor as well as methods for manufacturing them.

### Background Art

Conventionally, there have been bipolar transistors of a vertical NPN structure having an epitaxial base layer, and, among the bipolar transistors of this type, a heterojunction bipolar transistor (hereinafter, referred to as "SiGe HBT") having a base layer comprised of a silicon-germanium compound crystal layer is widely used as a apparatus required to operate at a high speed for use in, e.g., a frequency translator for communications equipment (see, for example, Unexamined Japanese Patent Application Laid-Open Specification No. 2003-257987).

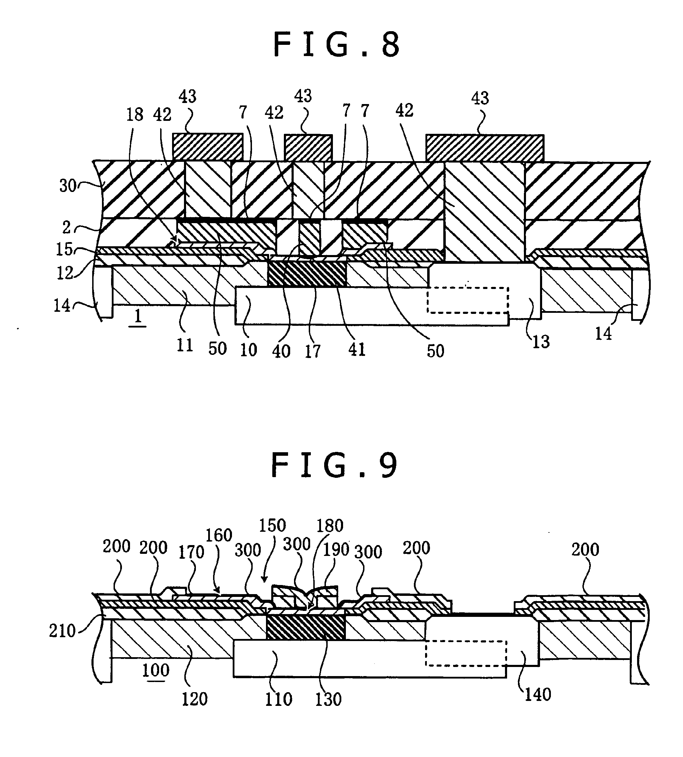

The structure of a general SiGe HBT having an epitaxial base layer is shown in FIG. 9 in which reference numeral 100 designates a P-type semiconductor substrate, 110 designates an N-type buried region formed in the semiconductor substrate 100, 120 designates an N-type epitaxial layer formed on the surface of the semiconductor substrate 100, 130 designates a collector region comprised of an N-type SIC (selection implantation collector) formed in the N-type epitaxial layer 120, and 140 designates an N-type collector lead region formed in the N-type epitaxial layer 120. Reference numeral 150 designates a base region comprised of a P-type epitaxial layer (SiGe layer) containing Ge, 160 designates a P-type epitaxial base layer, and 170 designates a base electrode lead portion (P-type) comprised of a polycrystalline SiGe layer. Reference numeral 180 designates an emitter region (N-type) formed from polycrystalline Si by impurity diffusion, and 190 designates an emitter electrode lead portion comprised of polycrystalline Si. Reference numeral 200 designates an insulating film, 210 designates an isolation layer, and 300 designates a metal silicide layer.

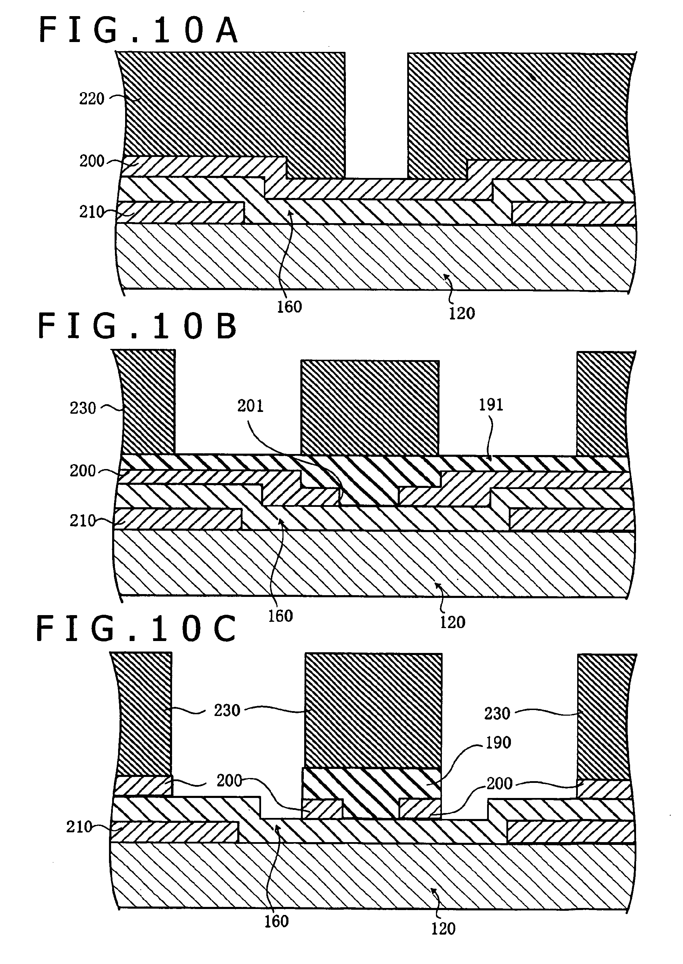

In this connection, with respect to the SiGe HBT of the above construction, an attention is drawn to the process for forming an emitter electrode. In a conventional process, as shown in FIG. 10A, the insulating film 200 comprised of an oxide film is formed on the base region 150 by a reduced pressure CVD process, and an opening is formed in the insulating film 200 by dry etching using a resist mask 220 to form a contact region for emitter first.

Then, as shown in FIG. 10B, polycrystalline silicon 191 constituting the emitter electrode lead portion 190 is formed by a reduced pressure CVD process. Subsequently, an oxide film for preventing contamination is formed by a reduced pressure CVD process, and then, ion implantation of As (arsenic) into the polycrystalline silicon 191 is conducted, and then the oxide film is removed by hydrofluoric acid or the like, and, as shown in FIG. 10C, the polycrystalline silicon 191 and the insulating film 200 are etched by dry etching using a resist mask 230 to form the emitter electrode lead portion 190.

As mentioned above, for forming the emitter electrode lead portion 190 by the conventional process, the formation of the contact region for emitter and the formation of the emitter electrode lead portion 190 need respective etching operations, that is, two separate etching operations are needed, and hence the resist mask 220 (230) is required per etching.

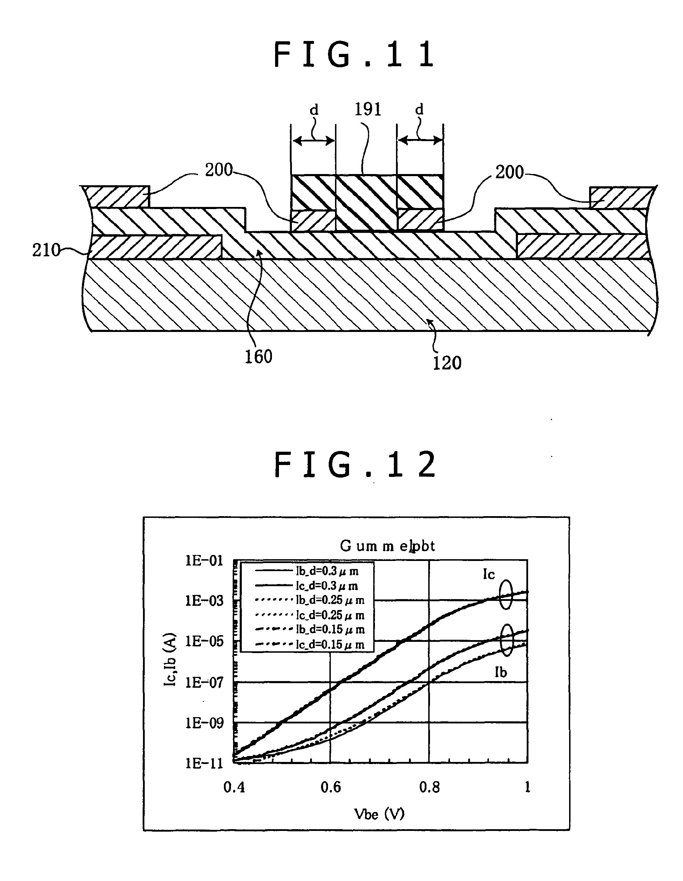

FIG. 11 shows an enlarged view of the emitter electrode lead portion 190 wherein character d designates a size of the width of a section constituting part of the emitter electrode lead portion 190. This size d is determined by a line width difference between the resist mask 220 {see FIG. 10A} used in the etching of the insulating film 200 for forming the contact region for emitter and the resist mask 230 {see FIG. 10C} used in the etching of the polycrystalline silicon 191 and insulating film 200 for forming the emitter electrode lead portion 190.

FIG. 12 is a graph showing, using the actual measurements, the relationship between the size d and a Gummel-plot of the SiGe HBT, namely, relationship between the dependency of a base current (Ib) on an emitter-base voltage (VBE) and the dependency of a collector current (Ic) on the emitter-base voltage (VBE).

A current gain (hFE) in the HBT is determined by the Ic/Ib and, as apparent from FIG. 12, as the d is reduced, the base current Ib is increased. The reason for this is presumed that the recombination of holes and electrons is promoted, but it is found that, when the d is reduced, the hFE determined by the Ic/Ib is lowered.

Accordingly, it is found that, when the two resist masks 220, 230 are respectively used in two etching operations as used in a conventional process, the size d is likely to vary due to the error of the alignment or the dispersion of the line width in any one of or both of the masks, leading to a problem in that hFE dispersion is caused between the semiconductor substrates or in the semiconductor substrate.

On the other hand, the SiGe HBT is used in a apparatus required to operate at a high speed as mentioned above, and therefore the SiGe HBT is strongly desired to be improved in high frequency characteristics.

As a method for improving the frequency characteristics of a bipolar transistor, shortening the base transit time is considered, and, in order to achieve this, it is necessary to reduce the base width. However, when the thickness of the epitaxial base layer 160 is reduced in the structure shown in FIG. 9, the thickness of each of the portion immediately below the emitter and the base electrode lead portion 170 is inevitably reduced, and such thickness reduction increases the base resistance, thus causing a problem in that the maximum operation frequency is lowered, the noise characteristics become poor, or the power consumption is increased.

A task of the present invention is to provide a bipolar transistor which can solve the above problems and a method for manufacturing the same, and a semiconductor apparatus having the bipolar transistor.

### Disclosure of the Invention

In the present invention according to claim 1, the method includes forming a base layer on a semiconductor substrate, and then forming in an insulating film stacked on the base layer a base electrode lead opening and an emitter electrode lead opening at the same time, and subsequently forming a base electrode lead portion and an emitter electrode lead portion in, respectively, the base electrode lead opening and the emitter electrode lead opening.

In the present invention according to claim 2, the base electrode lead portion and the emitter electrode lead portion are formed from the same conducting film at the same time.

In the present invention according to claim 3, the bipolar transistor includes a base electrode lead portion consisting of part of a base layer formed on a semiconductor substrate, wherein the base electrode lead portion and an emitter electrode lead portion are formed in correspondence with, respectively, a base electrode lead opening and an emitter electrode lead opening which are formed at the same time in an insulating film on the base layer.

In the present invention according to claim 4, the base electrode lead portion and the emitter electrode lead portion are formed from the same conducting film at the same time.

In the present invention according to claim 5, the method for manufacturing a semiconductor apparatus, which has a bipolar transistor having a base electrode lead portion consisting of part of a base layer formed on a semiconductor substrate, includes forming the base layer, and then forming in an insulating film stacked on the base layer a base electrode lead opening and an emitter electrode lead opening at the same time, and subsequently forming the base electrode lead portion and an emitter electrode lead portion in, respectively, the base electrode lead opening and the emitter electrode lead opening, thus forming the bipolar transistor.

I n the present invention according t o claim 6, the base electrode lead portion and the emitter electrode lead portion are formed from the same conducting film at the same time.

In the present invention according to claim 7, the semiconductor apparatus has a bipolar transistor which has a base electrode lead portion consisting of part of a base layer formed on a semiconductor substrate, wherein the bipolar transistor has the base electrode lead portion and an emitter electrode lead portion which are formed in correspondence with, respectively, a base electrode lead opening and an emitter electrode lead opening which are formed at the same time in an insulating film on the base layer.

In the present invention according to claim 8, the base electrode lead portion and the emitter electrode lead portion are formed from the same conducting film at the same time.

### Brief Description of the Drawings

**FIG. 1** is an explanatory view showing a fabrication process (first step) of a semiconductor apparatus according to the present embodiment.
FIG. 2 is an explanatory view showing a fabrication process (second step) of the semiconductor apparatus according to the present embodiment.
FIG. 3 is an explanatory view showing a fabrication process (third step) of the semiconductor apparatus according to the present embodiment.
FIG. 4 is an explanatory view showing a fabrication process (fourth step) of the semiconductor apparatus according to the present embodiment.
FIG. 5 is an explanatory view showing a fabrication process (fifth step) of the semiconductor apparatus according to the present embodiment.
FIG. 6 is an explanatory view showing a fabrication process (sixth step) of the semiconductor apparatus according to the present embodiment.
FIG. 7 is an explanatory view showing a fabrication process (seventh step) of the semiconductor apparatus according to the present embodiment.
FIG. 8 is an explanatory view showing a fabrication process (eighth step) of the semiconductor apparatus according to the present embodiment.
FIG. 9 is an explanatory view showing a conventional, general SiGe HBT.
FIGs. 10A-10C are explanatory views showing steps for forming an emitter electrode in a conventional, general SiGe HBT.
FIG. 11 is an enlarged explanatory view of an emitter electrode lead portion in the conventional, general SiGe HBT.
FIG. 12 is a graph showing the relationship between the dependency of a base current (Ib) on an emitter-base voltage (VBE) and the dependency of a collector current (Ic) on the emitter-base voltage (VBE).

### Best Mode for Carrying out the Invention

The method for manufacturing a bipolar transistor of the present invention comprises forming a base layer on a semiconductor substrate, and then forming in an insulating film stacked on the base layer a base electrode lead opening and an emitter electrode lead opening at the same time, and subsequently forming a base electrode lead portion and an emitter electrode lead portion in, respectively, the base electrode lead opening and the emitter electrode lead opening.

Specifically, a base layer is formed by epitaxial growth, and then an oxide film as an insulating film is stacked on the epitaxial base layer, and subsequently an emitter electrode lead opening is formed in the oxide film by dry etching using a mask and, using the mask used for forming the emitter electrode lead opening, a base electrode lead opening is formed simultaneously with forming the emitter electrode lead opening.

The emitter electrode lead opening and the base electrode lead opening are formed using the same mask at the same time as mentioned above, and therefore two masks are not needed wherein they are needed in a conventional process such that an opening is first formed in the emitter region by etching to form an emitter electrode lead opening, and then an opening is formed in the insulating film and a conducting film by etching upon forming an emitter electrode to form a base electrode lead opening.

When two separate masks are used, there is a fear that dispersion is caused in the alignment or the line width of each mask. Such dispersion causes dispersion of the width of the section constituting part of the emitter electrode (see FIGs. 10A-10C), leading to dispersion of a current gain (hFE). In the present embodiment, only a single mask is needed, and therefore dispersion due to the mask can be as small as possible, thus suppressing the current gain dispersion.

After the base electrode lead opening and the emitter electrode lead opening are formed at the same time, it is desired that the base electrode lead portion and the emitter electrode lead portion are formed from the same conducting film at the same time.

Specifically, two openings are formed by dry etching using a resist pattern, and then a conducting film comprised of, e.g., polycrystalline silicon is stacked. Then, the polycrystalline silicon is polished using CMP (chemical mechanical polishing) until such a height that an emitter region and a base electrode lead region are separated from each other is obtained, thus forming an emitter electrode in the emitter region and a base electrode lead portion comprised of the stacked polycrystalline silicon having an increased thickness in the base electrode lead region at the same time.

The base electrode lead portion and the emitter electrode lead portion are formed from the same conducting film at the same time as mentioned above, and therefore the base electrode lead portion formed in the base electrode lead opening has an increased thickness and hence the base resistance is lowered, thus making it possible to provide a higher-quality bipolar transistor.

In the present embodiment, the emitter electrode lead opening and the base electrode lead opening are formed using the same mask at the same time and therefore, as mentioned above, dispersion of the width of the section constituting part of the emitter electrode (see FIGs. 10A-10C) can be as small as possible. In addition, the base electrode lead portion and the emitter electrode lead portion are then formed from the same polycrystalline silicon at the same time, and therefore the base electrode lead portion comprised of the stacked polycrystalline silicon having an increased thickness can be formed, so that the resistance of the base layer can be lowered as well. Thus, a high-quality bipolar transistor can be provided without increasing the number of special steps or increasing the cost.

With respect to the increased thickness portion of the base electrode lead portion comprised of the polycrystalline silicon film used as a conducting film, it is preferred that implantation of impurities, such as As, is conducted, and the base resistance can be further lowered in this case.

A bipolar transistor obtained by the method described above can be preferably used in an SiGeBi CMOS having an SiGe heterojunction bipolar transistor (hereinafter, referred to as "SiGe HBT") and a MOS transistor or the like and a passive apparatus formed on the same semiconductor substrate, thus improving the performance of the apparatus required to operate at a high speed.

Hereinbelow, using a process for forming a PMOS transistor, an NMOS transistor, and an SiGe HBT of the present invention on the same substrate, the embodiment of the present invention will be described in detail with reference to the accompanying drawings. Here, the process comprises first to sixth steps, and the states of the SiGe HBT after completion of the individual steps are shown in the figures. The fabrication process for an MOS transistor is a known process and the description of this is omitted.

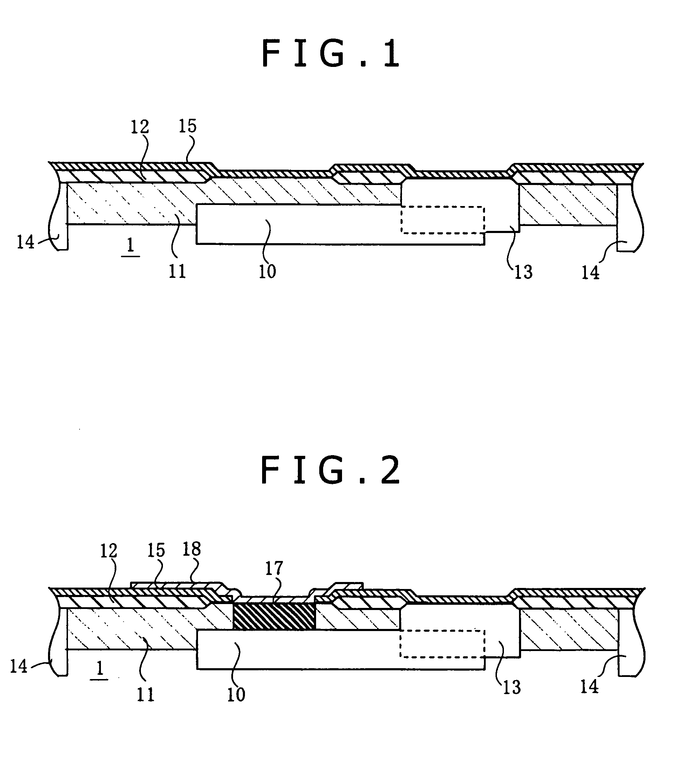

### (First step; FIG. 1)

In the first step, the surface of a P-type (100) silicon substrate 1 is subjected to oxide removal (sacrifice oxidation) using a chemical agent, such as hydrofluoric acid, and then subjected to thermal oxidation to form an oxide film of about 250 nm. Then, an opening is formed in the oxide film in the SiGe HBT formation region by dry etching using a resist pattern. An N⁺ buried layer 10 is then formed by Sb vapor phase diffusion using Sb₂O₃ at about 1,200°C. Then, the oxide film is removed from the surface of the substrate using a chemical agent, such as hydrofluoric acid, and then an N-type epitaxial layer (hereinafter, frequently referred to as "N-epi") 11 of 1.0 Ω•cm and 0.4 µm is formed by an epitaxial process. Then, a field oxide film 12 of about 300 to 500 nm is formed on the surface of the N-type epitaxial layer 11 by a LOCOS technique generally used.

Next, for removing the damaged layer caused during the LOCOS formation, an oxide film having a thickness of about 10 nm is formed by thermal oxidation (PRE.OX), and then, ion implantation using a resist pattern is conducted in the following order: (P⁺: 1 MeV, 5 x 10¹²/cm² → P⁺: 500 KeV, 5 x 10¹²/cm² → As⁺: 440 KeV, 3.8 x 10¹²/cm² → As⁺: 270 KeV, 3.8 × 10¹²/cm² → B⁺: 20 KeV, 2.7 x 10¹²/cm²), forming an N-type well region and a collector lead layer 13 in, respectively, a not shown PMOS region and the SiGe HBT region.

Further, ion implantation using a resist pattern is conducted in the following order: (B⁺: 600 KeV, 3 x 10¹²/cm² → B⁺: 190 KeV, 6 x 10¹²/cm² → B⁺: 70 KeV, 5 x 10¹²/cm² → B⁺: 20 KeV, 2 x 10¹²/cm²), forming a P-type well region and a P-type isolation layer 14 in, respectively, the NMOS formation region and the bipolar portion. If necessary, ion implantation for threshold voltage adjustment of the active surface in the MOS region is conducted to form a MOS having a plurality of threshold voltages, but this step is omitted here.

Next, the oxide film (PRE.OX) is removed using a chemical agent, such as hydrofluoric acid, and then an oxide film (gate oxide film) 15 of 5 to 8 nm is formed by thermal oxidation. Then, a low-resistance semiconductor film of about 100 nm comprised of, e.g., P-DAS (P-doped amorphous silicon) is formed by a reduced pressure CVD process or the like, and then tungsten silicide of about 100 nm is formed by an atmospheric CVD process or the like. Then, the tungsten silicide and P-DAS are removed by dry etching, such as RIE (reactive ion etching), using a resist pattern to form a gate electrode portion, followed by a heat treatment at 800°C for about 10 minutes.

Next, ion implantation using a resist pattern is conducted in the following order: (BF²⁺: 600 KeV, 2 x 10¹³/cm² → As⁺: 150 KeV, 2 x 10¹³/cm²), forming in the source/drain region in the PMOS region a P-type layer and an N-type layer for improving the dielectric strength.

Then, ion implantation using a resist pattern is conducted in the following order: (As⁺: 40 KeV, 2 x 10¹⁴/cm² → B⁺: 30 KeV, 7 x 10¹²/cm²), forming in the source/drain region in the NMOS region an N-type layer and a P-type layer for improving the dielectric strength.

Next, an oxide film of about 30 nm is formed by a reduced pressure CVD process or the like. Then, the oxide film is subjected to heat treatment in an oxygen gas atmosphere at 850°C for about 30 minutes to activate impurities.

Then, P-DAS of about 130 nm is formed by a reduced pressure DVD process or the like, and the entire surface is etched back to form an LDD (lightly doped drain) sidewall on the sidewall of the gate electrode.

Next, ion implantation using a resist pattern is conducted at (BF²⁺: 50 KeV, 1 × 10¹⁵/cm²) to form a source/drain in the PMOS region.

Then, ion implantation using a resist pattern is conducted at (As⁺: 50 KeV, 5 x 10¹⁵/cm²) to form a source/drain in the NMOS region.

Next, the entire surface is etched back to remove the LDD sidewall. The state after completion of the first step is shown in FIG. 1.

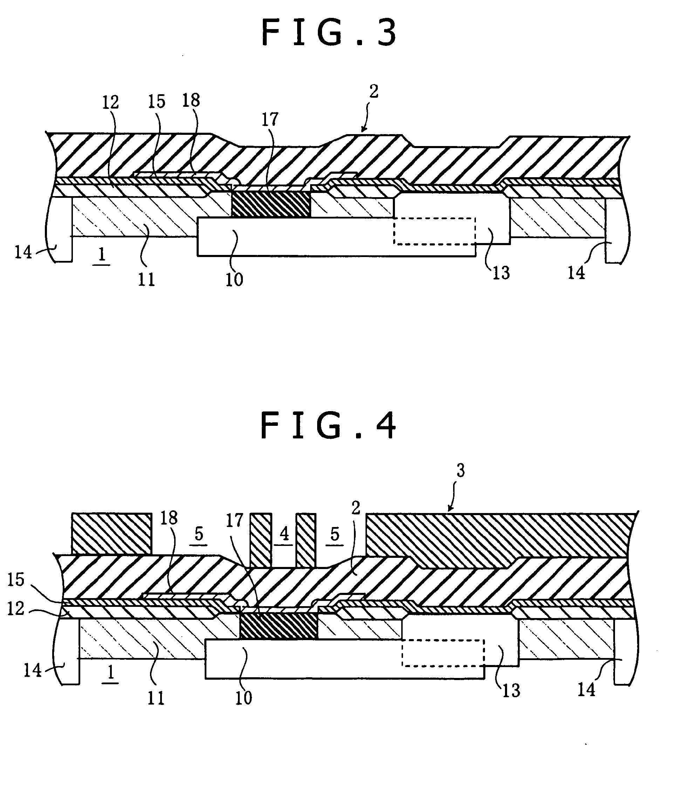

### (Second step; FIG. 2)

In the second step, an oxide film of about 100 nm is first formed by a reduced pressure CVD process or the like, and then subjected to heat treatment in a nitrogen gas atmosphere at 850°C for about 30 minutes.

Then, ion implantation of P⁺ into the active region of the SiGe HBT is conducted at about 300 KeV and 2 x 10¹²/cm² using a resist pattern to form an SIC layer 17.

Next, the oxide film is dry etched using the same resist pattern so that the surface of the underlying N-epi 11 is not etched, and an opening is formed in the oxide film 15 by wet etching using a chemical agent, such as hydrofluoric acid, so that the surface of the N-epi 11 is not damaged, exposing the N-epi 11, and then a P-type epitaxial base layer (SiGe layer) of 100 to 150 nm containing B (boron) and Ge is formed by an epitaxial process. In this instance, a single crystal SiGe layer is formed on the exposed surface of the N-epi 11, and a polycrystalline SiGe layer is formed on the remaining SiO₂ surface.

Then, a base layer 18 of the SiGe HBT is formed by dry etching using a resist pattern. The state after completion of the second step is shown in FIG. 2.

### (Third step; FIG. 3)

In the third step, an oxide film 2 of about 400 to 1,000 nm is first formed by an HDP-CVD process (high-density plasma chemical vapor deposition process) or the like using TEOS (tetla-ethyl-ortho-silicate) as a raw material. The state after completion of the third step is shown in FIG. 3.

### (Fourth step; FIG. 4)

Next, an emitter electrode lead opening 4 of the SiGe HBT and a base electrode lead opening 5 are formed in the oxide film 2 at the same time by dry etching using a resist pattern 3 as a mask. The state after completion of the fourth step is shown in FIG. 4.

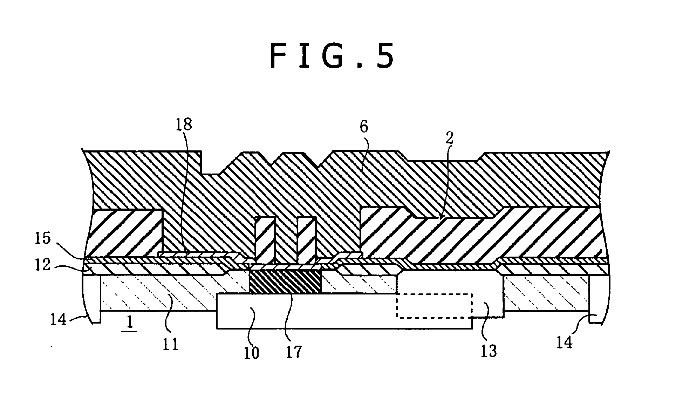

### (Fifth step; FIG. 5)

Next, polycrystalline silicon 6 of about 400 to 600 nm is formed by a reduced pressure CVD process or the like. The state after completion of the fifth step is shown in FIG. 5.

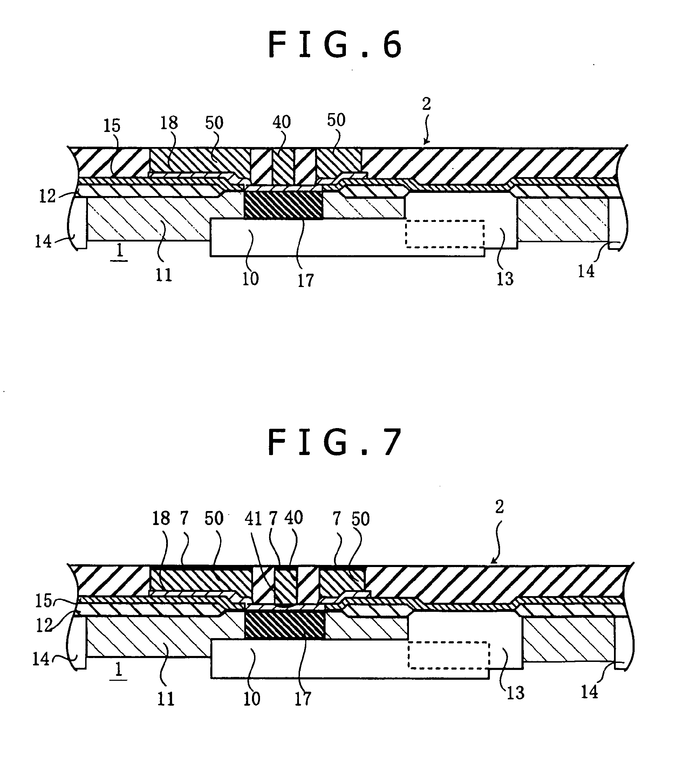

### (Sixth step; FIG. 6)

Next, the polycrystalline silicon is polished using a CMP (chemical mechanical polishing) process until an emitter electrode lead portion 40 and a base electrode lead portion 50 are separated from each other to achieve insulation. For example, the polycrystalline silicon is polished so that the oxide film 2 on the base layer 18 become 150 to 300 nm and the surface of the substrate is polished for planarization.

In this instance, for enhancing the insulation of the emitter electrode lead portion 40 and the base electrode lead portion 50, after the polishing, the polycrystalline silicon 6 may be etched back by dry etching so that the polycrystalline silicon 6 is smaller than the thickness of the oxide film 2. The state after completion of the sixth step is shown in FIG. 6.

### (Seventh step; FIG. 7)

Next, an oxide film of about 30 nm for preventing contamination is formed by a reduced pressure CVD process, and then ion implantation of As⁺ into the polycrystalline silicon 6 constituting the emitter electrode lead portion 40 is conducted using a resist pattern at about 30 to 40 kev and 1 x 10¹⁵ to 1 × 10¹⁶/cm². Then, ion implantation of BF²⁺ into the base electrode lead portion 50 is conducted using the resist pattern at about 25 to 40 kev and 1 x 10¹⁴ to 5 x 10¹⁵/cm², lowering the resistance of the polycrystalline silicon 6 constituting the base electrode lead portion 50.

Then, the oxide film for preventing contamination is removed using a chemical agent, such as hydrofluoric acid, and then another oxide film of about 100 nm is formed, and subjected to heat treatment in a nitrogen gas atmosphere at 800°C for about 10 minutes, and subjected to RTA (rapid thermal annel) in a nitrogen gas atmosphere at 1,000°C for about 10 seconds, so that As in the polycrystalline silicon 6 undergoes thermal diffusion from the emitter electrode lead portion 40, thus forming an emitter region 41 in the base layer 18. Then, the oxide film of 100 nm formed before the heat treatment is removed using a chemical agent, such as hydrofluoric acid.

Next, a metal film of about 15 nm comprised of Co or Ti and a metal film oxidation preventing film of about 30 nm comprised of TiN are successively formed by a sputtering process.

The metal film is then subjected to heat treatment by an RTP (rapid thermal process) in, e.g., a nitrogen gas atmosphere at 500°C for about 30 seconds to form metal silicide 7.

Next, the unreacted metal film is removed from the oxide film using a chemical agent, such as ammonia hydrogen peroxide mixture.

Then, the metal silicide is subjected to heat treatment using an RTP in, e.g., a nitrogen gas atmosphere at 700°C for about 30 seconds to lower the resistance of the metal silicide 7. The state after completion of the seventh step is shown in FIG. 7.

### (Eighth step; FIG. 8)

In the subsequent step for forming wirings, the same planarization technique as that used in a conventional technique is employed, and a brief description is shown below.

An oxide film 30 of about 600 to 1,000 nm as an interlayer film is formed by an HDP-CVD process (high-density plasma chemical vapor deposition process) or the like using TEOS (tetla-ethyl-ortho-silicate) as a raw material, and then the surface of the substrate is subjected to planarization using CMP (chemical mechanical polishing). Next, a metal contact is formed, and the contact portion having no metal silicide 7 (source/drain region of the MOS portion) is subjected to contact ion implantation and heat treatment for activation and then, a metal electrode 42, a multilayer interconnect 43, and an over coat are formed, thus forming a semiconductor apparatus having an SiGe HBT having a lowered parasitic resistance. The finished state after completion of the eighth step is shown in FIG. 8. In the figure, one layer of the multilayer interconnect 43 is shown.

As described above, in the fourth to sixth steps, the emitter electrode lead opening 4 and the base electrode lead opening 5 are formed using the single resist pattern 3 as a mask at the same time, and then the base electrode lead portion 50 and the emitter electrode lead portion 40 are formed from the same polycrystalline silicon 6 at the same time, and therefore, not only can dispersion of the current gain (hFE) be as small as possible, but also the base electrode lead portion 50 comprised of the stacked polycrystalline silicon 6 having an increased thickness can be formed, so that the resistance of the P-type epitaxial base layer 18 can be lowered as well.

### INDUSTRIAL APPLICABILITY

In the present invention, the method comprises forming a base layer on a semiconductor substrate, and then forming in an insulating film stacked on the base layer a base electrode lead opening and an emitter electrode lead opening at the same time, and subsequently forming a base electrode lead portion and an emitter electrode lead portion in, respectively, the base electrode lead opening and the emitter electrode lead opening. Therefore, in the process for manufacturing a bipolar transistor, the etching for forming a base electrode lead region and an emitter region in the insulating film needs only one common mask, so that dispersion of the line width of the emitter electrode can be as small as possible, thus making it possible to provide a high-quality bipolar transistor free of current gain dispersion. The thus obtained bipolar transistor is used in a semiconductor apparatus, such as an SiGeBi CMOS, improving the performance of the apparatus required to operate at a high speed.

Further, the base electrode lead portion and the emitter electrode lead portion are formed from the same conducting film at the same time, and hence the base electrode lead portion has an increased thickness, making it possible to provide a high-quality bipolar transistor having a lowered base resistance. This bipolar transistor is used in a semiconductor apparatus, such as an SiGeBi CMOS, thus further improving the performance of the apparatus required to operate at a high speed.

## Claims

1. A method for manufacturing a bipolar transistor, **characterized by** comprising:
forming a base layer on a semiconductor substrate;
forming in an insulating film stacked on said base layer a base electrode lead opening and an emitter electrode lead opening at the same time; and
subsequently forming a base electrode lead portion and an emitter electrode lead portion in, respectively, said base electrode lead opening and said emitter electrode lead opening.

2. The method for manufacturing a bipolar transistor as described in claim 1, **characterized in that** said base electrode lead portion and said emitter electrode lead portion are formed from the same conducting film at the same time.

3. A bipolar transistor having a base electrode lead portion consisting of part of a base layer formed on a semiconductor substrate, said bipolar transistor **characterized in that** said base electrode lead portion and an emitter electrode lead portion are formed in correspondence with, respectively, a base electrode lead opening and an emitter electrode lead opening which are formed at the same time in an insulating film on said base layer.

4. The bipolar transistor as described in claim 3, **characterized in that** said base electrode lead portion and said emitter electrode lead portion are formed from the same conducting film at the same time.

5. A method for manufacturing a semiconductor apparatus which has a bipolar transistor having a base electrode lead portion consisting of part of a base layer formed on a semiconductor substrate, said method **characterized by** comprising:
forming said base layer;
forming in an insulating film stacked on the base layer a base electrode lead opening and an emitter electrode lead opening at the same time; and
subsequently forming the base electrode lead portion and an emitter electrode lead portion in, respectively, the base electrode lead opening and the emitter electrode lead opening, thus forming the bipolar transistor.

6. The method for manufacturing a semiconductor apparatus as described in claim 5, **characterized in that** said base electrode lead portion and said emitter electrode lead portion are formed from the same conducting film at the same time.

7. A semiconductor apparatus which has a bipolar transistor having a base electrode lead portion consisting of part of a base layer formed on a semiconductor substrate, said semiconductor apparatus **characterized in that** said bipolar transistor has the base electrode lead portion and an emitter electrode lead portion which are formed in correspondence with, respectively, a base electrode lead opening and an emitter electrode lead opening which are formed at the same time in an insulating film on said base layer.

8. The semiconductor apparatus as described in claim 7, **characterized in that** said base electrode lead portion and said emitter electrode lead portion are formed from the same conducting film at the same time.
